# EUROPÄISCHE PATENTSCHRIFT

(11) **EP 1 240 673 B1**
(45) Veröffentlichungstag und Bekanntmachung des Hinweises auf die Patenterteilung: **18.08.2010**
(21) Anmeldenummer: 00985147.8
(22) Anmeldetag: 07.12.2000
(51) Int. Cl.: H01L 31/0236, H01L 31/18, H01L 21/306, H01L 21/3213

(54) **Verfahren zur Rauhätzung von Siliziumsolarzellen**
Method for raw etching silicon solar cells
Procédé de gravure de cellules solaires au silicium pour les rendre rugueuses

(30) Priorität: 22.12.1999 DE 19962136
(43) Veröffentlichungstag der Anmeldung: 18.09.2002
(73) Patentinhaber: BASF SE, 67056 Ludwigshafen (DE)
(72) Erfinder: KÜBELBECK, Armin, 64625 Bensheim (DE); Wiegand, Claudia, 64291 Darmstadt (DE); GÖLZENLEUCHTER, Thomas, 64572 Büttleborn (DE)
(86) Internationale Anmeldenummer: PCT/EP2000/012328
(87) Internationale Veröffentlichungsnummer: WO 2001/047032

(56) Entgegenhaltungen:
- DE-A- 19 746 706
- US-A- 3 953 263
- US-A- 4 137 123
- US-A- 5 949 123
- R. EINHAUS ET AL.: "Recent progress with acidic texturing solutions on different multicrystalline silicon materials including ribbons" 2ND WORLD CONFERENCE ON PHOTOVOLTAIC SOLAR ENERGY CONVERSION, Bd. II, 6. - 10. Juli 1998, Seiten 1630-1633, XP002166724 VIENNA, AT
- R. EINHAUS ET AL.: "ISOTROPIC TEXTURING OF MULTICRYSTALLINE SILICON WAFERS WITH ACIDIC TEXTURING SOLUTIONS" 26TH IEEE PHOTOVOLTAIC SPECIALISTS CONFERENCE, 29. September 1997 (1997-09-29) - 3. Oktober 1997 (1997-10-03), Seiten 167-170, XP002166725 ANAHEIM, CA, USA
- VERLINDEN P ET AL: "THE SURFACE TEXTURIZATION OF SOLAR CELLS: A NEW METHOD USING V-GROOVES WITH CONTROLLABLE SIDEWALL ANGLES" SOLAR ENERGY MATERIALS AND SOLAR CELLS,NL,ELSEVIER SCIENCE PUBLISHERS, AMSTERDAM, Bd. 26, Nr. 1 / 02, 1. März 1992 (1992-03-01), Seiten 71-78, XP000264537 ISSN: 0927-0248

## Beschreibung

Die vorliegende Erfindung betrifft ein neues Verfahren, zur Herstellung von strukturierten Oberflächen auf multikristallinen, trikristallinem und monokristallinen Siliziumoberflächen von Solarzellen oder auf Siliziumsubstraten, welche für photovoltaische Zwecke angewendet werden. Sie betrifft insbesondere ein Ätzverfahren sowie ein Ätzmittel zur Herstellung einer strukturierten Oberfläche auf einem Siliziumsubstrat.

Monokristalline bzw. multikristalline Solarzellen werden typischerweise aus massiven gezogenen Siliziumstäben, respektive aus gegossenen Siliziumblöcken, per Drahtsäge herausgeschnitten (Dietl J., Helmreich D., Sirtl E., Crystals: Growth, Properties and Applications, Vol. 5 Springer Verlag 1981, S. 57 und 73). Eine Ausnahme davon bildet das nach dem weiter unten beschriebenen EFG-Verfahren (Edge defined Film Growth) gezogene Silizium (Wald, F.V.; Crystals: Growth, Properties and Applications, Vol. 5 Springer Verlag 1981, S 157).

Eine relativ neue Entwicklung ist dabei das sogenannte "Trikristalline Silizium" (US 5,702,538), welches im folgenden wie multikristallines Silizium behandelt wird.

Das so gesägte monokristalline bzw. multikristalline Silizium hat eine rauhe Oberfläche, auch als Sägeschaden bezeichnet, mit Rauhtiefen von ca. 20-30 µm. Für die weitere Verarbeitung der Solarzelle, insbesondere aber für die Erzielung eines möglichst hohen Wirkungsgrades, ist eine sogenannte Sägeschadenätzung (engl. Damage Etch) notwendig. Bei dieser Sägeschadenätzung werden die in den Gräben der Oberfläche befindlichen Kontaminationen entfernt. Dies sind besonders Metallabrieb vom Sägedraht, aber auch Schleifmittelspuren. Diese Ätzung wird typischerweise in ca. 30 %iger Kali- oder Natronlauge bei Temperaturen von ca. 70°C und höher durchgeführt. Bedingt durch die auch unter diesen Bedingungen relativ niedrige Ätzrate von ca. 2 µm/min sind Ätzzeiten >10 min notwendig, um den gewünschten Effekt zu erreichen. Durch diese Ätzung wird eine rauhe Oberfläche auf dem Substrat erzeugt. Die dabei an der Oberfläche erzielten Öffnungswinkel sind sehr flach und für eine Reflexionsminderung oder gar Mehrfachreflexion an der Oberfläche völlig ungeeignet. Solche Reflexions-Effekte sind zur Erzielung hoher Wirkungsgrade der Zelle aber erwünscht. Eine Vielzahl von Veröffentlichungen und Patenten beschäftigt sich daher mit der Reflexionsminderung an Solarzellen jeglichen Types z.B. auch für amorphe Solarzellen (US 4,252,865 A).

Bei monokristallinem Silizium kann die Reflexionsminderung dadurch erreicht werden, daß die Siliziumscheiben nach der Sägeschadenätzung mit ca. 5-10 % iger Kali- oder Natronlauge geätzt werden (engl. Texture Etch). Durch die anisotrope Ätzung (Heuberger A., "Mikromechanik", Springer Verlag 1989; Price J.B., "Semiconductor Silicon", Princeton N.J. 1983, S 339) werden willkürliche Pyramiden ("random pyramids) mit <111> Kristallorientierung (Goetzberger A., Voß B., Knobloch J.; Sonnenenergie: Photovoltaik, Teubner Studienbücher 1997, S. 178 f.) und Kantenlängen von ca. 1-10 µm aus dem <100> orientierten Basismaterial herausgeätzt. Ein US-Patent (US 4,137,123 A) beschäftigt sich ausführlich mit diesem Verfahren.

Dieses Verfahren versagt jedoch bei multikristallinem Silizium, da das Basismaterial keine gerichtete Kristallorientierung, sondern eine Vielzahl von Orientierungsebenen hat.

Das nach dem EFG-Verfahren gezogene multikristalline Silizium weist keine Sägeschäden in der Ebene auf, da der Herstellprozeß keinen Sägeprozeß beinhaltet. Zur Erzielung höherer Wirkungsgrade wäre jedoch auch hier, wie bei den gegossenen und gesägten multikristallinen Zellen, eine Texturierung vorteilhaft. Jedoch versagt aufgrund der Multikristallinität des Materials auch hier die Erzeugung von willkürlichen Pyramiden.

Neben dem Eingangs beschriebenen anisotropen Ätzen mit starken Laugen sind an sich sechs konkurrierende Verfahren bekannt, mit denen eine optisch günstige Oberflächenstruktur an der Siliziumoberfläche insbesondere für multikristalline Solarzellen erzeugt werden kann.

Diese sind:
1. Sandstrahlen/perlen
   Die Oberfläche wird hierbei durch den mechanischen Beschuß feinster Sand oder Korund oder Siliziumkarbidpartikel aufgerauht [JP 59-82778(1984)]. Das
   Verfahren ist mechanisch sehr aufwendig und sowohl die Prozeßführung als auch die Kontamination der Oberfläche mit kationischen Verunreinigungen, werden als ausgesprochen ungünstig eingeschätzt.
2. Fräsen
   Hierbei werden in die Oberfläche des Substrates V-förmige Gräben hineingefräst [DE19930043]. Nachteilig ist der hohe mechanische Aufwand und die Kontamination mit Metallabrieb. Eine nachfolgende Reinigung und Ätzung ist erforderlich und kostenintensiv. Zudem kann die allgemein angestrebte dünnere Auslegung des Siliziums zur Kostenreduzierung nicht angewendet werden.
3. Anodische Oxidation
   Bei der anodischen Oxidation wird das zu strukturierende Siliziumsubstrat z.B. in einer Mischung aus 1 Volumenteil 50 %iger Flußsäure und 1 Volumenteil Ethanol anodisch mit Platinelektroden geätzt. Auf diese Weise wird ein nanoporöses Silizium mit einer hochaktiven Oberfläche erzeugt. Das Verfahren ist in der Mikromechanik bekannt und zeichnet sich durch einen sehr geringen Durchsatz (zeitaufwendiges Einzelsubstratverfahren) und einen hohen apparativen Aufwand aus.
4. Sputter Ätzen
   Auch dieses in JP 58 15238 (1983) beschriebene Verfahren zeichnet sich durch einen erheblichen apparativen Aufwand aus.
5. LASER gestützte Verfahren
   Hierbei wird entweder mit LASER Unterstützung anisotrop mit NaOH oder KOH geätzt (US 5,081,049) bzw. werden direkt per LASER grabenförmige Strukturen auf das Substrat aufgebracht (US 4,626,613). Auch hier ist der apparative Aufwand ausgesprochen hoch und zudem der Durchsatz einer solchen Anlage stark limitiert.
6. Photolithographische Strukturierung
   Nach einer Beschichtung mit einem Photoresist wird eine Struktur, z.B. aus Kreisen oder Linien auf das Substrat belichtet und entwickelt. Anschließend wird z.B. mit einer Mischung aus Salpetersäure, Essigsäure und Flußsäure eine isotrope Ätzung in das Silizium durchgeführt. Dabei entstehen aus den Kreisen konusartige Löcher bzw. aus den Linien V-förmige Gräben. Das sehr aufwendige und teure Verfahren ist beispielsweise in US 5,702,538 beschrieben.

Aus DE 19746706 ist eine Ätzmischung zur Herstellung einer strukturierten Oberfläche auf einer Solarzelle aus ein kristallinen oder polykristallinen Silizium bekannt, welches hauptsächlich aus Flusssäure, Salpetersäure und Phosphorsäure besteht.

Aufgabe der vorliegenden Erfindung ist es daher ein preiswertes und in einfacher Weise durchführbares, preiswertes Verfahren zur Herstellung von strukturierten Oberflächen auf multikristallinen, trikristallinen und monokristallinen Siliziumoberflächen von Solarzellen oder von Siliziumsubstraten, welche für photovoltaische Zwecke angewendet werden, zur Verfügung zu stellen, welches die oben genannten Nachteile nicht aufweist. Aufgabe der vorliegenden Erfindung ist es auch, ein Mittel zur Durchführung des Verfahrens zur Verfügung zu stellen.

Die erfindungsgemäße Aufgabe wird gelöst durch, eine neue Ätzmischung und ein Verfahren in dem diese Mischung verwendet wird.

Gegenstand der vorliegenden Erfindung ist eine Ätzmischung zur Herstellung einer strukturierten Oberfläche auf multikristallinen, trikristallinen und monokristallinen Siliziumoberflächen von Solarzellen oder von Siliziumsubstraten, für photovoltaische Zwecke, enthaltend Flußsäure, Salpetersäure und Schwefelsäure.

Insbesondere ist eine Ätzmischung Gegenstand der vorliegenden Erfindung, enthaltend Flußsäure, Salpetersäure, Schwefelsäure und Phosphorsäure.

Als besonders wirkungsvoll haben sich solche Ätzmischungen gezeigt, die ein zusätzliches Oxidationsmittel, welches die Bildung von Stickoxiden unterbindet und gegebenenfalls eine oberflächenaktive Substanz ausgewählt aus der Gruppe der polyfluorierten Amine oder der Sulfonsäuren enthalten.

In den Rahmen der vorliegenden Erfindung fallen auch entsprechende Ätzmischungen, die ein zusätzliches Oxidationsmittel ausgewählt aus der Gruppe Wasserstoffperoxid, Ammoniumperoxidsulfat und Perchlorsäure enthalten.

Erfindungsgemäß wird die vorliegende Aufgabe durch Ätzmischungen, enthaltend 1 - 30 % HF, 5 - 30% Salpetersäure, 50 bis 94 % konzentrierte Schwefelsäure oder 50 bis 94 % eines Gemischs aus konzentrierter Schwefelsäure und konzentrierter Phosphorsäure gelöst.

Insbesondere erfolgt die Lösung der erfindungsgemäßen Aufgabe auch durch ein Verfahren zur Herstellung von strukturierten Oberflächen auf multikristallinen, trikristallinem und monokristallinen Siliziumoberflächen von Solarzellen oder von Siliziumsubstraten, für photovoltaische Zwecke , indem
a) eine Ätzmischung wie oben charakterisiert, bei geeigneter Temperatur durch Sprühen, Tauchen, Kapillar- oder Meniskusbeschichten mit der gesamten Oberfläche in Kontakt gebracht wird, wodurch ein isotropes Anätzen erfolgt
   und
b) nach ausreichender Einwirkzeit die Ätzmischung abgespült wird.

In einer besonderen Ausführungsform des erfindungsgemäßen Verfahrens erfolgt neben der Strukturätzung eine Sägeschadenätzung. Dieses wird dadurch erzielt, indem eine Ätzmischung, welche 10 - 16 % HF, 20 - 30 % HNO₃, 15 - 25 % H₂SO₄, 14 - 20 % H₃PO₄ und 20 - 30 % Wasser enthält, verwendet wird.

Gute Ergebnisse werden erzielt, indem der Ätzvorgang bei einer Temperatur zwischen 15 und 30°C, insbesondere bei Raumtemperatur durchgeführt wird und eine Einwirkzeit zwischen 2 und 30 Minuten gewählt wird.

Eine weitere Verfahrensvariante besteht darin, daß zur Rauhätzung eine Ätzmischung verwendet wird, welche 3-7 % HF, 3 - 7 % HNO₃, 75 - 85 % H₂SO₄ und 5 - 15 % Wasser enthält, und welche nach einer Einwirkzeit von 1-5 Minuten abgespült wird.

Wie beschrieben, bestanden u.a. bei der Texturierung von multikristallinem Silizium Probleme bei der alkalischen Sägeschadenätzung und der Erzeugung einer reflexionsmindernden Oberfläche.

Ein bekanntes Verfahren zur Herstellung rauher Oberflächen auf Siliziumsubstraten in der Mikroelektronik ist das sogenannte Spin Etch Verfahren, welches in US 4,903,717 beschrieben wird. In einem Teilschritt dieses Verfahrens wird die Siliziumoberfläche aufgerauht, um eine verbesserte Haftung der dünngeätzen Microchips beim Bonden auf den Carrier zu erzielen. Hierbei werden kommerziell vertriebene Ätzmischungen, z.B. Spinetch^{®}E, verwendet.

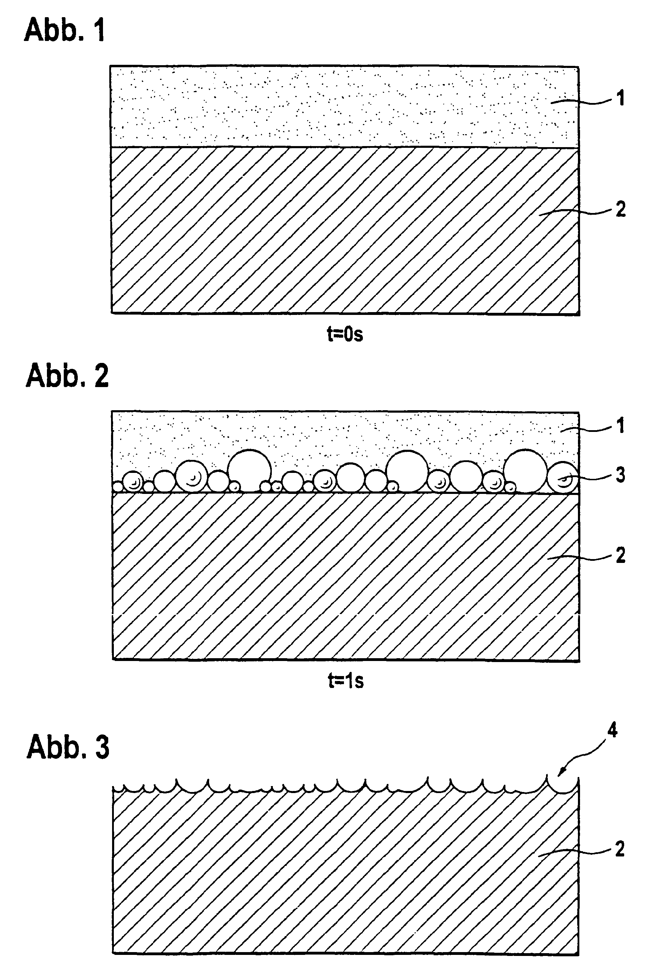

Durch Untersuchungen des Rauhätzeffektes und durch Veränderung der Ätzmischungen wurde gefunden, daß im wesentlichen ein Gasblaseneffekt für die Rauhätzung verantwortlich ist. Nach dem Auftragen einer geeigneten Ätzmischung (1) auf ein Siliziumsubstrat (2) (Abb. 1) oder Eintauchen des Siliziums in die Ätzmischung, bilden sich an der Oberfläche des Siliziumsubstrates (2) in weniger als einer Sekunde nach dem Aufbringen, kleinste Gasbläschen (3) aus Nitrosen Gasen (Abb. 2). Untersuchungen haben gezeigt, daß wenn die Ätzmischung einen Zusatz von Wasserstoffperoxid oder Ammoniumperoxidisulfat enthält, entstehen statt der nitrosen Gase Bläschen aus Sauerstoff. Die Gasblasen (3) behindern örtlich die weitere Ätzung des Siliziums, da sie durch ihr Anwachsen und Festsitzen an der Oberfläche des Siliziums die weitere Zufuhr an Ätzmischung zum Silizium (2) erschweren. Dadurch ergeben sich Inhomogenitäten in der Ätzrate, verteilt über das Substrat. Dieser Effekt führt letztlich (Abb. 3) zu einer Aufrauhung der Oberfläche des Siliziums (4).

Durch Variation der äußeren Parameter (z.B. Temperatur, Zeit, Medienführung über das Substrat) und vor allem auch durch die Zusammensetzung der Ätzmischung, kann die Rauheit der Oberfläche in weiten Grenzen beeinflußt werden. Die Form und Radien der Gasbläschen, insbesondere aber deren Kontaktfläche zum Silizium sind dabei entscheidend zum Erzielen des gewünschten aufrauhenden Effektes.

Durch die Versuche wurde gefunden, daß eine um so rauhere Oberfläche erzielt werden kann je kleiner die auf der Oberfläche haftenden Gasbläschen während des Ätzvorgangs sind. Ziel der neuen Entwicklung mußte es daher sein, die Bildung größerer Bläschen, die dann auch meist nicht mehr sphärisch sind und dadurch eine größere Kontaktfläche zum Silizium bilden und so in größeren Flächen die Ätzung behindern, möglichst zu unterdrücken.

Es wurde gefunden, daß diese Ziel durch gezielte Variation und Wahl der Ätzmischungskomponenten sowie der weiteren Ätzparameter erreicht werden kann. Als besonders vorteilhaft erwies es sich, als Basis der Ätzmischung eine hochviskose Mineralsäure wie z.B. Phosphorsäure oder Schwefelsäure, zu verwenden, da durch die Viskosität die Bildung und Stabilisierung insbesondere von kleinsten sphärischen Gasbläschen deutlich gefördert wird. Durch weitere Versuche wurde gefunden, daß durch Zusatz oberflächenaktiver Substanzen, die in diesen Ätzmischungen stabil sind, wie beispielsweise polyfluorierte Amine oder Sulfonsäuren, die Anzahl und Eigenschaften der Gasbläschen vorteilhaft beeinflußt werden können.

Die Ätzmischung kann durch verschiedene, dem Fachmann geläufige Verfahren, auf das Siliziumsubstrat gebracht werden. Ein sehr einfaches Verfahren ist dabei das Eintauchen, bevorzugt mehrerer Substrate gleichzeitig, in die Ätzmischung. Ebenfalls geeignet sind Sprühverfahren in Durchlaufanlagen. Besonders günstig bezüglich des Materialverbrauches ist dabei die einseitige Beschichtung des Substrates nur auf der Vorderseite, bei dem gerade das für die Ätzung notwendige Material aufgebracht wird. Vorteilhafte Verfahren hierzu sind beispielsweise in US 5,455,062 und DE 19600985 beschrieben. Die Ätzmischung wird dabei bis zu deren "Erschöpfungspunkt" ausgenutzt und anschließend abgespült. Dies gewährleistet zudem eine hohe Prozeßglcichmäßigkeit, da stets frische, unverbrauchte Ätzlösung dem Substrat zugeführt wird.

Die Zusammensetzung der Ätzmischung kann dabei, unabhängig vom Verarbeitungsverfahren so gewählt werden, daß neben dem erwünschten Aufrauhungseffekt, parallel auch eine Sägeschadenätzung stattfindet. Dies ist besonders bei multikristallinem, gegossenem Silizium sehr vorteilhaft. Für EFG-Silizium ist dieses Verfahren nicht notwendig.

Ein positiver Nebeneffekt der erfindungsgemäßen sauren Rauhätzung ist, daß, vorausgesetzt es sind entsprechend reine Ausgangsmaterialien verwendet worden, keine kationische Kontamination des Substrates stattfindet. Vorteilhafter Weise werden gegebenenfalls vorhandene Kontaminationen durch Metalle (Fe, Ti, Ni, usw.) an der Substratoberfläche in lösliche Verbindungen überführt und mit dem Abspülen der sauren Strukturätze entfernt. Zusätzliche Reinigungs- und Spülschritte, wie sie bei der alkalischen Ätzung notwendig sind, können daher entfallen.

Von besonderem Vorteil ist die nach dem erfindungsgemäßen Verfahren erzielbare hohe Ätzrate, welche insbesondere durch die Wahl der verwendeten Ätzmischung beeinflußt wird. Diese schlägt sich im Vergleich zu der alkalischen Ätzung insbesondere in erheblich kürzeren Prozeßzeiten nieder.

Als wesentlicher und unverzichtbarer Bestandteil der wirksamen Ätzmischungen hat sich Flußsäure erwiesen, auch wenn sie nicht zwingend in hohen Konzentrationen eingesetzt werden muß. Bereits 1 % Flußsäure in der Ätzmischung kann ausreichend sein. Typischerweise liegen die Konzentrationen im Bereich von 1 - 30 % HF, besonders vorteilhaft im Bereich von 3 bis 15% HF. Als oxidative Komponente können in der Ätzmischung Salpetersäure, Wasserstoffperoxid, Perchlorsäure oder ähnliche Oxidationsmittel bzw. Gemische dieser Verbindungen enthalten sein. Als besonders günstig hat es sich aufgrund der Stabilität der Lösung erwiesen, wenn in der Ätzmischung Salpetersäure in einem Konzentrationsbereich von 5 - 30 % enthalten ist.

Wie bereits zuvor erwähnt ist ein höher viskoses Basismaterial für die Ausbildung und Fixierung von Gasbläschen besonders vorteilhaft. Der Anteil dieser Basiskomponente, die auf den eigentlichen chemischen Ätzmechanismus keine unmittelbare Auswirkung hat, beträgt typischerweise 50-94 %, bezogen auf die Gesamtmischung. Ausgesprochen günstig ist dabei der Einsatz von konzentrierter Schwefelsäure, die neben der notwendigen Viskosität eine Erhöhung der Ätzrate und die Bindung des im Ätzprozeß gebildeten Wassers, vorteilhaft in die Mischung einbringt.

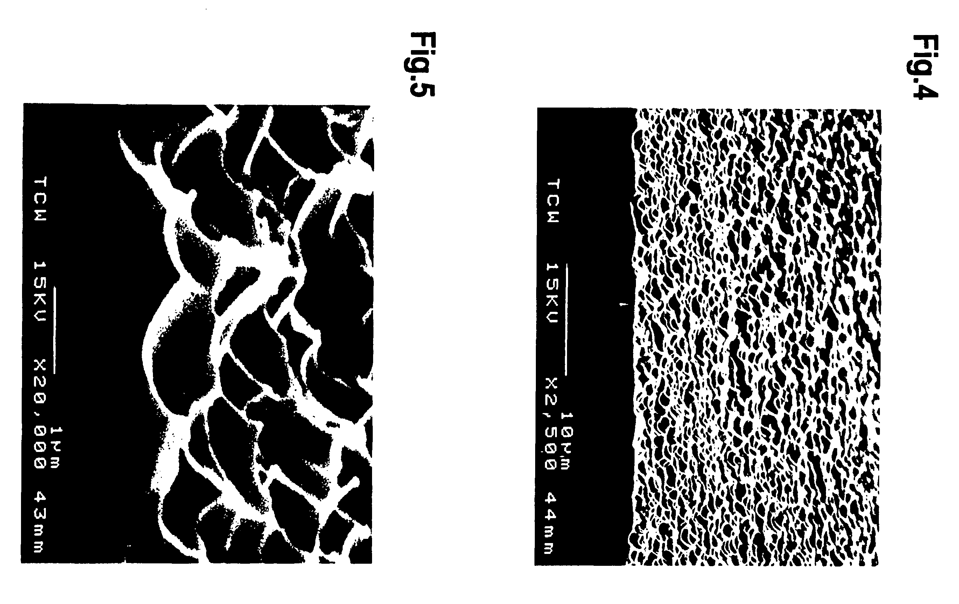

Versuche haben gezeigt, daß zur Rauhätzung Ätzmischungen verwendet werden können, welche 3-7 % HF, 3 - 7 % HNO₃, 75 - 85 % H₂SO₄ und 5 - 15 % Wasser enthalten. Durch Einwirkzeiten zwischen 1 - 5 Minuten werden gute Ergebnisse erhalten. Eine typische Rauhätze zur Erzeugung einer Rauhigkeit mit Strukturtiefen und -breiten von ca. 1-3 µm hat folgende Zusammensetzung: 5% HF, 5% HN03, 80% H2S04, 10% H20. Bei einer Einwirkzeit von ca. 2 min und der Verarbeitung bei Raumtemperatur, wird nach dem Eintauchen des Siliziumsubstrates in die beschriebene Ätzmischung, die in Abb. 4 abgebildete Oberflächenstruktur erhalten. Deutlich sind die durch die Ätzung erzeugten steilen Flanken der Ätzkrater in Abb. 5 zu erkennen. Diese steilen Flanken sind für eine Wirkungsgraderhöhung einer Solarzelle sehr vorteilhaft. Die integrale Ätzrate bei dieser Ätzung beträgt dabei nach DIN 50453 T1 ca. 2 µm/min bei 20°C.

Weiterhin wurde gefunden, daß neben der Strukturätzung eine Sägeschadenätzung auf der Siliziumoberfläche erzielt werden kann, wenn eine Ätzmischung verwendet wird, die 10-16% HF, 20-30% HNO₃, 15-25% H₂SO₄, 14 - 20 % H₃PO₄ und 20 - 30 % Wasser enthält,

Eine Sägeschadenätzmischung mit Aufrauhwirkung, welche zu guten Ergebnissen führt, hat beispielsweise folgende Zusammensetzung: 13% HF, 25% HNO3, 20% H2S04, 17% H3PO4, 25%H20.

Nach einer Einwirkungszeit von 30 min und einer integralen Ätzrate von ca.130 µm/min werden die durch das Sägen des Wafers vorgegebenen Strukturen weggeätzt und die gewünschte Aufrauhung der Oberfläche erhalten.

Allgemein wurde gefunden, daß nach dem erfindungsgemäßen Verfahren gute Ätzergebnisse erzielt werden, indem der Ätzvorgang bei einer Temperatur zwischen 15 und 30°C, insbesondere bei Raumtemperatur durchgeführt wird und eine Einwirkzeit zwischen 2 und 30 Minuten gewählt wird.

Die bei der Ätzung entstehenden nitrosen Gase sind wegen ihrer Toxizität unerwünscht. Zur Unterdrückung der Bildung von nitrosen Gasen hat sich daher der Zusatz einer zweiten oxidierenden Komponente erwiesen. Geeignete Zusätze sind z.B. Wasserstoffperoxid, Ammoniumperoxidisulfat u. a. , wie sie in US 3,953,263 genannt sind. Der Zusatz solcher Komponenten hat den vorteilhaften Effekt, daß die Bildung nitroser Gase unterbunden wird, statt dessen jedoch Sauerstoffbläschen gebildet werden, die den gleichen Effekt während des Ätzvorgangs haben.

## Patentansprüche

1. Ätzmischung zur Herstellung einer strukturierten Oberfläche auf multikristallinen, trikristallinen und monokristallinen Siliziumoberflächen von Solarzellen oder auf Siliziumsubstraten, für photovoltaische Zwecke, enthaltend Flusssäure, Salpetersäure und Schwefelsäure.

2. Ätzmischung gemäß Anspruch 1, enthaltend Phosphorsäure.

3. Ätzmischung gemäß der Ansprüche 1 - 2, **gekennzeichnet durch** ein zusätzliches Oxidationsmittel, welches die Bildung von Stickoxiden unterbindet und gegebenenfalls eine oberflächenaktive Substanz ausgewählt aus der Gruppe der polyfluorierten Amine oder der Sulfonsäuren.

4. Ätzmischung gemäß der Ansprüche 1-3, **gekennzeichnet durch** ein zusätzliches Oxidationsmittel ausgewählt aus der Gruppe Wasserstoffperoxid, Ammoniumperoxidsulfat und Perchlorsäure.

5. Ätzmischung gemäß der Ansprüche 1-4. enthaltend 1 - 30 % HF, 5 - 30% Salpetersäure, 50 bis 94 % konzentrierte Schwefelsäure oder 50 bis 94 % eines Gemischs aus konzentrierter Schwefelsäure und konzentrierter Phosphorsäure.

6. Verfahren zur Herstellung von strukturierten Oberflächen auf multikristallinen, trikristallinem und monokristallinen Siliziumoberflächen von Solarzellen oder auf Siliziumsubstraten für photovoltaische Zwecke,
indem
a) eine Ätzmischung gemäß der Ansprüche 1 bis 5 bei geeigneter Temperatur durch Sprühen, Tauchen, Kapillar- oder Meniskusbeschichten mit der gesamten Oberfläche in Kontakt gebracht wird, wodurch ein isotropes Anätzen erfolgt
und
b) nach ausreichender Einwirkzeit die Ätzmischung abgespült wird..

7. Verfahren gemäß Anspruch 6, **dadurch gekennzeichnet, daß** neben der Strukturätzung eine Sägeschadenätzung erfolgt, indem eine Ätzmischung, welche 10 -16 % HF, 20 - 30 % HNO₃, 15 - 25 % H₂SO₄, 14 - 20 % H₃PO₄ und 20 - 30 % Wasser enthält, verwendet wird.

8. Verfahren gemäß der Ansprüche 6 bis 7, **dadurch gekennzeichnet, daß** der Ätzvorgang bei einer Temperatur zwischen 15 und 30°C, insbesondere bei Raumtemperatur durchgeführt wird.

9. Verfahren gemäß der Ansprüche 6 bis 8, **dadurch gekennzeichnet, daß** eine Einwirkzeit zwischen 2 und 30 Minuten gewählt wird.

10. Verfahren gemäß Anspruch 6, **dadurch gekennzeichnet, daß** eine Ätzmischung welche 3-7 % HF, 3 - 7 % HNO₃, 75 - 85 % H₂SO₄ und 5 -15 % Wasser enthält, zur Rauhätzung verwendet wird und nach einer Einwirkzeit von 1 - 5 Minuten abgespült wird.

## Claims

1. An etching mixture for producing a textured surface on multicrystalline, tricrystalline and monocrystalline silicon surfaces of solar cells or on silicon substrates, for photovoltaic purposes, comprising hydrofluoric acid, nitric acid and sulfuric acid.

2. The etching mixture according to claim 1, comprising phosphoric acid.

3. The etching mixture according to claims 1-2, **characterized by** an additional oxidizing agent which suppresses the formation of nitrogen oxides and, if appropriate, a surface-active substance selected from the group consisting of the polyfluorinated amines and the sulfonic acids.

4. The etching mixture according to claims 1-3, **characterized by** an additional oxidizing agent selected from the group consisting of hydrogen peroxide, ammonium peroxide sulfate and perchloric acid.

5. The etching mixture according to claims 1-4, comprising 1-30% HF, 5-30% nitric acid, 50 to 94% concentrated sulfuric acid or 50 to 94% of a mixture of concentrated sulfuric acid and concentrated phosphoric acid.

6. A process for producing textured surfaces on multicrystalline, tricrystalline and monocrystalline silicon surfaces of solar cells or on silicon substrates for photovoltaic purposes, in which
a) an etching mixture according to claims 1 to 5 is brought into contact with the entire surface at a suitable temperature by spraying, dipping, capillary coating or meniscus coating, resulting in incipient isotropic etching, and
b) the etching mixture is rinsed off after a sufficient duration of action.

7. The process according to claim 6, wherein in addition to the texture etching damage etching takes place, in which an etching mixture which comprises 10-16% HF, 20-30% HNO₃, 15-25% H₂SO₄, 14-20% H₃PO₄ and 20-30% water is used.

8. The process according to claims 6 to 7, wherein the etching operation is carried out at a temperature of between 15 and 30°C, in particular at room temperature.

9. The process according to claims 6 to 8, wherein a duration of action of between 2 and 30 minutes is selected.

10. The process according to claim 6, wherein an etching mixture which comprises 3-7% HF, 3-7% HNO₃, 75-85% H₂SO₄ and 5-15% water is used for the rough-etching and is rinsed off after a duration of action of 1-5 minutes.

## Revendications

1. Mélange décapant pour la fabrication d'une surface structurée sur des surfaces de silicium multicristallines, tricristallines et monocristallines de cellules solaires ou sur des substrats en silicium, à des fins photovoltaïques, contenant de l'acide fluorhydrique, de l'acide nitrique et de l'acide sulfurique.

2. Mélange décapant selon la revendication 1, contenant de l'acide phosphorique.

3. Mélange décapant selon les revendications 1 à 2, **caractérisé par** un oxydant supplémentaire, qui empêche la formation d'oxydes d'azote, et éventuellement une substance tensioactive choisie dans le groupe des amines polyfluorées ou des acides sulfoniques.

4. Mélange décapant selon les revendications 1 à 3, **caractérisé par** un oxydant supplémentaire, choisi dans le groupe du peroxyde d'hydrogène, du persulfate d'ammonium et de l'acide perchlorique.

5. Mélange décapant selon les revendications 1 à 4, contenant 1 à 30% d'HF, 5 à 30% d'acide nitrique, 50 à 94% d'acide sulfurique concentré ou 50 à 94% d'un mélange d'acide sulfurique concentré et d'acide phosphorique concentré.

6. Procédé de fabrication de surfaces structurées sur des surfaces de silicium multicristallines, tricristallines et monocristallines de cellules solaires ou sur des substrats en silicium, à des fins photovoltaïques, selon lequel
a) une mélange décapant selon les revendications 1 à 5 est mis en contact à une température appropriée par pulvérisation, immersion, enduction capillaire ou laminaire avec la totalité de la surface, un décapage isotrope ayant lieu
et
b) après un temps d'action suffisant, le mélange décapant est rincé.

7. Procédé selon la revendication 6, **caractérisé en ce qu'**un décapage des dégâts liés au sciage a lieu en plus du décapage de structuration en utilisant un mélange décapant qui contient 10 à 16% d'HF, 20 à 30% d'HNO₃, 15 à 25% d'H₂SO₄, 14 à 20% d'H₃PO₄ et 20 à 30% d'eau.

8. Procédé selon les revendications 6 à 7, **caractérisé en ce que** le processus de décapage est réalisé à une température comprise entre 15 et 30 °C, notamment à température ambiante.

9. Procédé selon les revendications 6 à 8, **caractérisé en ce qu'**un temps d'action compris entre 2 et 30 minutes est choisi.

10. Procédé selon la revendication 6, **caractérisé en ce qu'**un mélange décapant qui contient 3 à 7% d'HF, 3 à 7% d'HNO₃, 75 à 85% d'H₂SO₄ et 5 à 15% d'eau est utilisé pour le décapage de rugosification et rincé après une temps d'action de 1 à 5 minutes.
